# EUROPÄISCHE PATENTSCHRIFT

(11) **EP 0 376 055 B1**
(45) Veröffentlichungstag und Bekanntmachung des Hinweises auf die Patenterteilung: **23.06.1993**
(21) Anmeldenummer: 89122988.2
(22) Anmeldetag: 13.12.1989
(51) Int. Cl.: H05K 3/34

(54) **Verfahren zum Löten eines drahtlosen Bauelementes sowie Leiterplatte mit angelötetem, drahtlosem Bauelement**
Method of soldering a wireless component and circuit board with a soldered wireless component
Procédé de soudage d'un élément sans fil et circuit imprimé comportant un composant sans fil soudé

(30) Priorität: 27.12.1988 DE 3843984
(43) Veröffentlichungstag der Anmeldung: 04.07.1990
(73) Patentinhaber: ASEA BROWN BOVERI AG, 5400 Baden (CH)
(72) Erfinder: Dahnke, Günther, D-7890 Waldshut-Tiengen 2 (DE)

(56) Entgegenhaltungen:
- DE-A- 3 636 817
- FR-A- 2 613 898
- GB-A- 2 149 581
- US-A- 4 515 304
- FEINWERKTECHNIK & MESSTECHNIK vol. 94, no. 6, August 1986, DE Seiten 351 - 355; O. WINTELER: "lÖTEN VON SMD'S AUF LEITERPLATTEN"

## Beschreibung

### TECHNISCHES GEBIET

Bei der Erfindung wird ausgegangen von einem Verfahren zum Löten eines drahtlosen Bauelementes an eine Leiterplatte-Metallanschlussfläche nach dem Oberbegriff des Patentanspruchs 1 sowie von einer Leiterplatte mit mindestens einem drahtlosen Bauelement nach dem Oberbegriff des Patentanspruchs 6.

### STAND DER TECHNIK

Mit dem Oberbegriff der Patentansprüche 1 und 6 nimmt die Erfindung auf einen Stand der Technik Bezug, wie er aus der DE-C3-2 852 753 bekannt ist. Dort wird zum Befestigen filmartiger Bauelemente mit flächigen Anschlusskontakten auf Leiterbahn-Anschlussstellen an der Oberseite einer Leiterplatte flüssiges Lot durch durchkontaktierte Löcher im Bereich der Anschlussstellen von der Unterseite der Leiterplatte zu den Anschlusskontakten gebracht. Der Lochdurchmesser liegt im Bereich von 0,3 mm - 1,6 mm. Die Bauelemente werden während des Lötvorganges mittels einer Schablone an der Leiterplatte gehalten.

Nachteilig dabei ist, dass für jede Bauelementanordnung ein oder mehrere Schablonen erforderlich sind. Für Lochdruchmesser unter 0,3 mm ist ein Durchschieben der Leiterplatte durch ein Lötbad nicht geeignet, um eine sichere Lötung zu gewährleisten. Fluxgase können beim Löten schlecht entweichen.

Aus der deutschen Druckschrift: Helmut Müller, OMB/SMD Oberflächenmontierte Bauelemente in der Leiterplattentechnik, Eugen G. Lenze Verlag, D-7968 Saulgau/Württ., 1986, S. 69 - 74, ist es bekannt, oberflächenmontierbare Bauelemente (OMB) vor dem Löten auf einer der beiden Seiten der Leiterplatte in der gewünschten geometrischen Position mittels eines Klebers zu fixieren. Damit wird beim Löten ein Dejustieren verhindert.

Die Bauelemente weisen insbesondere randseitig 2 metallische Lötanschlüsse auf, die durch Wellen- bzw. Schwallöten mit 2 metallischen Anschlussflächen, welche unterhalb oder oberhalb dieser Lötanschlüsse auf der Leiterplatte angebracht sind, verlötet werden. Falls eine Durchkontaktierung zur gegenüberliegenden Seite der Leiterplatte erforderlich ist, so ist diese neben die Anschlussfläche plaziert und (zur Wärmesperre) mit einer dünnen Leiterbahn verbunden. Es sind Lötverfahren für unterschiedliche Bestückungskombinationen angegeben. Wenn auf der gleichen Bauelementseite der Leiterplatte sowohl bedrahtete als auch OMB-Bauelemente vorkommen, so sind 2 Lötverfahren anzuwenden: Kontaktlöten und Wellenlöten oder Reflowlöten (Wiederaufschmelzen der Lötpaste durch Infrarotlöten oder Kondensationslöten) und Wellenlöten.

Nachteilig dabei ist, dass bei Bauelement-Kombinationen, bei denen nur das Wellenlöten angewendet wird, die OMB-Bauelemente nur auf der Lötseite der Leiterplatte angelötet werden können und dabei eine Löttemperatur von 240 °C - 260 °C aushalten müssen. Ansonsten sind 2 Lötverfahren oder das Reflow-Löten (nur OMB-Bauelemente auf einer Seite der Leiterplatte) anzuwenden, was aufwendig und teuer ist.

### DARSTELLUNG DER ERFINDUNG

Die Erfindung, wie sie in den Patentansprüchen 1 und 6 definiert ist, löst die Aufgabe, ein Verfahren zum Löten eines drahtlosen Bauelementes derart weiterzuentwickeln, dass auch für kleinere Lochdurchmesser eine grössere Zuverlässigkeit der Lötung gewährleistet wird, sowie eine Leiterplatte der eingangs genannten Art anzugeben, die rationeller und zuverlässiger herstellbar ist.

Ein Vorteil der Erfindung besteht darin, dass diese Bauelemente rationeller und insbesondere kostengünstiger gelötet werden können. Eine Bauelementschablone ist nicht erforderlich. Durch den freien Abzug der Fluxgase entfallen sonst unerwünschte Begleiterscheinungen, wie narbige Oberflächen bei Chipträgern und Flachbauelementen und der sogenannte Grabstein-Effekt. Drahtlose Bauelemente, welche die Temperatur des flüssigen Lotes nicht vertragen, lassen sich, auch zusammen mit bedrahteten Bauelementen, in nur einem Lötvorgang löten, und zwar von der bezüglich der Bauelemente entgegengesetzten Seite der Leiterplatte.

Gemäss einer vorteilhaften Ausgestaltung der Erfindung können thermisch belastbare drahtlose Bauelemente zusätzlich auch auf der Lötseite der Leiterplatte angeordnet sein und zusammen mit den Bauelementen auf der Bauelementseite mit nur einem gemeinsamen Fliesslöten gelötet werden. Dabei können die Zahl der Arbeitsgänge verringert und somit Kosten eingespart werden.

Wenn drahtlose Bauelemente an beiden Seiten der Leiterplatte anzubringen sind, entfällt das Siebdrucken der Lötpaste mit allen damit zusammenhängenden Problemen, wie: Pastenqualität, Pastenalterung, Pastenmenge, Verschmierung der Paste, Verarbeitungszeitraum zwischen Pastenauftrag und Lötung, Siebreinigung und Unterhalt. Die direkte Wärmebelastung der Bauelemente durch Infrarot- oder Dampfphasenlötung entfällt. Der Nachlötaufwand ist geringer, da die Lötqualität von weniger Faktoren beeinflusst wird.

Aufgrund einer konkaven Ausbildung der endseitigen Lötoberfläche lassen sich die Leiterplatten über Kontaktierungspunkte besser prüfen, wobei die Prüfung nur von der Lötseite her erfolgt. Durch die direkten Kontaktstellen werden kurze Signallaufzeiten, sowie geringe Induktivitäten und Kapazitäten erreicht.

### KURZE BESCHREIBUNG DER ZEICHNUNGEN

Die Erfindung wird nachstehend anhand von Ausführungsbeispielen erläutert. Es zeigen:
- Fig. 1 u. 2: nicht massstabgerechte Querschnitte durch Abschnitte einer Leiterplatte mit an deren Bauelementseite angelöteten, unterschiedlichen drahtlosen Bauelementen,
- Fig. 3: eine Draufsicht auf das Bauelement gemäss Fig. 2 mit 2 Metallanschlussflächen und
- Fig. 4: einen Querschnitt durch eine Leiterplatte mit gemischter Bestückung von bedrahteten und drahtlosen Bauelementen.

### WEGE ZUR AUSFÜHRUNG DER ERFINDUNG

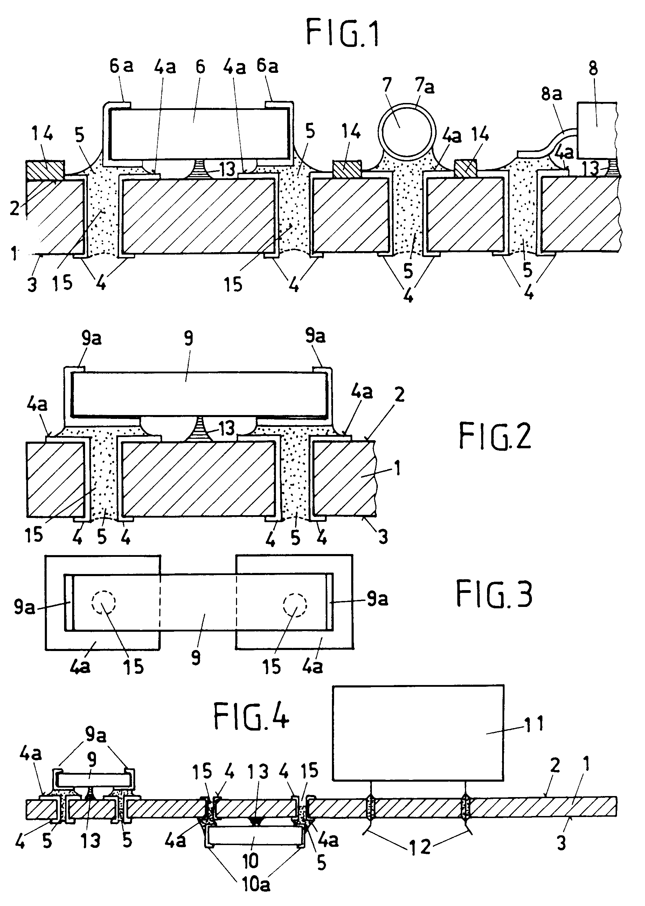

In den Fig. 1 und 2 sind mit 1 eine Leiterplatte mit einer oberen Bauelementseite 2 und einer unteren Lötseite 3 bezeichnet. 4 verschieden gestaltete und kontaktierte oberflächenmontierbare, elektrische Bauelemente 6, 7, 8 und 9 sind auf der Bauelementseite 2 der Leiterplatte 1 über randseitige, metallische Lötanschlusselemente 6a bzw. 7a, 8a, 9a mit Leiterplatte-Metallanschlussflächen 4a von Lochmetallisierungen 4 mittels eines Lotes 5 verlötet. Das Lötanschlusselement 8a ist ein abgewinkeltes Lötanschlussbeinchen, das an einer Stirnseite eines nur teilweise dargestellten quaderförmigen Bauelementes 8 angebracht ist, welches mit seinem Bauelementkörper von der Leiterplatte 1 beabstandet und nur über das Lötanschlussbeinchen 8a und einen nichtleitenden Kleber 13 an der Leiterplatte 1 fixiert ist. Die Bauelemente 6 - 9 können z.B. Miniatur-Widerstände, -Kondensatoren, -Ferrite, -Quarze, -Schalter, integrierte Schaltkreise oder diskrete Halbleiter sein.

Mit 15 sind Bohr- bzw. Lötlöcher von 0,3 mm - 0,4 mm Durchmesser bezeichnet, die zumindest teilweise unterhalb der Lötanschlusselemente 6 - 9 angeordnet und randseitig sowie in einem kleinen Bereich oberhalb und unterhalb der Leiterplatte 1 mit der Lochmetallisierung 4 versehen sind. Die Lochmetallisierung 4 besteht aus Kupfer, das nachträglich heissluftverzinnt ist. Mit 14 ist in Fig. 1 eine Lötstoppabdeckung bzw. Schutzbeschichtung auf der Bauelementseite 2 der Leiterplatte 1 angedeutet, welche auch auf der Lötseite 2 (nicht dargestellt) vor der Heissluftverzinnung aufgebracht wird und die Lochmetallisierung flächenmässig begrenzt.

Die Leiterplatte-Metallanschlussflächen 4a sind die auf der Bauelementseite 2 der Leiterplatte 1 befindlichen Teile der Lochmetallisierungen 4, die als Auflagestellen für die Anschlüsse 6a - 9a der Bauelemente 6 - 9 vorzugsweise als rechteckige, insbesondere als quadratische Flächen, vgl. Fig. 3, ausgeführt sind.

Die Herstellung der mit oberflächenmontierbaren Bauelementen 6a - 9a bestückten Leiterplatte 1 erfolgt nach folgendem Arbeitsablauf:
a) in die Leiterplatte 1 werden Bohrlöcher 15 gebohrt,
b) auf den gewünschten Leiterbahnen und Bohrlöchern 15 der Leiterplatte 1 wird Kupfer abgeschieden,
c) die Flächen der Leiterplatte 1, welche keine Lochmetallisierung 4 erhalten sollen, werden mit Lötstoppabdeckung 14 versehen,
d) danach folgt eine Heissluftverzinnung,
e) auf der Bauelementseite 2 der Leiterplatte 1 wird punktförmig nichtleitender Klebstoff 13 zur Fixierung der Bauelementkörper der Bauelemente 6 - 9 aufgetragen,
f) die Bauelemente 6 - 9 werden auf der Bauelementseite 2 der Leiterplatte 1 in der gewünschten Position auf den jeweiligen Kleber 13 aufgesetzt; dabei verbleibt bei den Bauelementen 6 - 9 zwischen der Leiterplatte-Metallanschlussfläche 4a und dem jeweiligen Lötanschlusselement 6a - 9a ein Abstand von 100 µm - 150 µm,
g) der Kleber 13 wird durch Wärmebehandlung ausgehärtet,
h) Fliesslöten bzw. Wellenlöten von der Lötseite 3 der Leiterplatte 1 her.

Das Lötloch 15 hat die Funktion einer Wärmebrücke; gleichzeitig dient es als Abzug für Fluxgase, die sich aus dem Fliessmittel des Lötzinns bilden. Es erlaubt ein konventionelles Fliesslöten von der Unterseite 3 der Leiterplatte 1, vermeidet eine übermässige Zinnanhäufung auf der Oberseite 2 und erhöhte Bauelement-Erwärmung während des Lötprozesses. Beim Fliesslöten saugt das Lötloch infolge der Kapillarwirkung und des freien Abzuges der Fluxgase das Lötzinn nach oben, so dass eine sichere und saubere Lötverbindung ohne unerwünschte Begleiterscheinungen, wie genarbte Oberflächen und Grabsteineffekt, gewährleistet ist.

Fig. 4 zeigt eine Leiterplatte 1 mit einer Mischbestückung von oberflächenmontierbaren Bauelementen 9 und 10 mit einem bedrahteten Bauelement 11, dessen Lötanschlussdrähte 12 von der Bauelementseite 2 her durch die Leiterplatte 1 geführt sind.

Das Bauelement 10 mit 2 randseitigen metallischen Lötanschlusselementen 10a ist an 2 Leiterplatte-Metallanschlussflächen 4a von heissluftverzinnten Lochmetallisierungen 4 an der Lötseite 3 der Leiterplatte 1 angelötet, wobei die Lötlöcher 15 im Bereich der Lötanschlusselemente 10a vorgesehen sind. Das Lötzinn 5 füllt die Lötlöcher 15 nur teilweise. Diese Lötung reicht aus, um das Bauelement 10 von der Bauelementseite 2 her zu kontaktieren. Das Bauelement 10 kann auch in herkömmlicher Weise an der Lötseite 3 der Leiterplatte 1 angelötet sein, wobei keine Lötlöcher 15 im Bereich der Lötanschlusselemente 10a vorgesehen sind (nicht dargestellt).

Alle 3 Bauelemente werden durch nur ein Fliesslöten von der Lötseite 2 der Leiterplatte 1 her verlötet. Das Bauelement 10 muss dabei während einer Lötdauer im Bereich von 1 s - 3 s die Löttemperatur im Bereich von 240 °C - 260 °C aushalten. Die Bauelemente 9 und 11 auf der Bauelementseite 2 der Leiterplatte 1 werden beim Löten thermisch weniger stark belastet.

Wesentlich bei der vorliegenden Erfindung ist die Anordnung der Lötlöcher 15, die statt rund auch rechteckig, dreieckig usw. ausgeführt sein können, unterhalb oder oberhalb der Lötanschlusselemente 6a - 10a der oberflächenmontierbaren Bauelemente 6 - 10. Wie in Fig. 1 in Verbindung mit dem Bauelement 6 angedeutet, reicht es, wenn sich die Lötanschlusselemente 6a nur teilweise über den 2 Lötlöchern 15 befinden.

Es versteht sich, dass statt Zinn auch ein anderes Lot, wie z.B. Bleilot oder Zinklot, verwendet werden kann.

Für das Fliesslöten eignet sich besonders eine turbulente Lötwelle, deren Turbulenz durch einen in seiner Vibrationsamplitude und ggf. in seiner Frequenz einstellbaren Oszillator erzeugt wird. Ein derartiges Lötverfahren ist u.a. durch das Bulletin No. 154-01 der kanadischen Firma ELECTOVERT Ltd., 1305 Industrial Blod., La Prairie, Quebec, Canada I5R2E4, Ausgabe 1986, bekannt. Die Vibrationsamplitude liegt vorzugsweise im Bereich von 0,75 mm - 1,5 mm, die Oszillatorfrequenz vorzugsweise bei 50 Hz oder 60 Hz.

Die Turbulenz kann auch mittels einer Doppelwelle, bestehend aus einer Hohlwelle und einer nachfolgenden Vollwelle, erzeugt werden, wie es aus dem Firmenprospekt der Schweizer Firma: EPM Handels AG, CH-8035 Zürich, Beckenhofstr. 16, "Rechnergesteuerte Doppelwellen-Lötautomaten für SMD und/oder konventionelle Bauteile mit Computer Aided Quality Control (CAD)", Ausgabe 1989, bekannt ist.

Für die durchmetallisierten Lötlöcher 15 sind bereits Lötdurchmesser ab 0,2 mm geeignet, insbesondere für kleine Anschlussflächen, und Lochdurchmesser bis 0,9 mm für grosse Anschlussflächen.

Der vertikale Abstand der Leitanschlusselemente 6a - 10a der Bauelemente 6 - 10 von der jeweiligen Leiterplatte-Metallanschlussfläche 4a liegt vorzugsweise im Bereich von 100 µm - 250 µm. Beim Löten gewährleistet dieser Luftzwischenraum einen guten Abzug der Fluxgase.

Die Leiterplatte-Metallanschlussfläche 4a der Lochmetallisierung 4 ist vorzugsweise flächenmässig grösser als die entsprechende Fläche der Lochmetallisierung auf der Gegenseite der Leiterplatte 1, an der kein Bauelement angelötet ist. Damit bleibt mehr Platz für Bauelemente.

## Patentansprüche

1. Verfahren zum Löten eines drahtlosen Bauelementes (6 - 10) an eine Leiterplatte-Metallanschlussfläche (4a),
a) die vor dem Löten an einer ersten bzw. Bauelementseite (2) einer Leiterplatte (1) angebracht wird,
b) wobei das Bauelement mindestens ein metallisches Lötanschlusselement (6a - 10a) aufweist und
c) vor dem Löten auf der Bauelementseite der Leiterplatte in der gewünschten Lötposition in seiner geometrischen Lage so fixiert wird, dass sich mindestens ein Bereich oder Abschnitt mindestens eines metallischen Lötanschlusselementes (6a - 10a) des Bauelementes (6 - 10) in einer vertikalen Verlängerung eines Endes eines Lötloches (15) in der Leiterplatte (1) befindet,
d) wobei danach das mindestens eine metallische Lötanschlusselement des Bauelementes von der Lötseite der Leiterplatte her durch Fliesslöten an mindestens eine Leiterplatte-Metallanschlussfläche (4a) gelötet wird,
dadurch gekennzeichnet,
e) dass das Lötanschlusselement (6a - 10a) des Bauelementes (6 - 10) vor dem Löten von der Leiterplatte-Metallanschlussfläche (4a) durch einen Luftzwischenraum beabstandet ist, so dass Fluxgase beim Löten entweichen können.

2. Verfahren nach Anspruch 1, dadurch gekennzeichnet, dass das Fliesslöten mit einer turbulenten Lötwelle erfolgt, deren Turbulenz durch einen Oszillator mit vorgebbarer Vibrationsamplitude oder mittels einer Doppelwelle aus einer Hohl- und einer nachfolgenden Vollwelle zumindest mitbewirkt wird.

3. Verfahren nach Anspruch 1 oder 2, dadurch gekennzeichnet, dass sich das Bauelement (10) auf einer der Bauelementseite gegenüberliegenden zweiten bzw. Lötseite (3) der Leiterplatte (1) befindet.

4. Verfahren nach einem der Ansprüche 1 bis 3, dadurch gekennzeichnet, dass das Lötanschlusselement (6a - 10a) von einem Ende des Lötloches (15) bzw. von der Leiterplatte-Metallanschlussfläche (4a) einen vertikalen Mindestabstand von 100 µm aufweist.

5. Verfahren nach einem der Ansprüche 1 bis 4, dadurch gekennzeichnet,
a) dass das drahtlose Bauelement (6 - 10) vor dem Löten zum Fixieren der geometrischen Lage auf die Leiterplatte (1) geklebt wird und
b) dass der Kleber vor dem Löten durch Wärmebehandlung gehärtet wird.

6. Leiterplatte (1) mit mindestens einem drahtlosen Bauelement (6 - 10),
a) das mindestens ein metallisches Lötanschlusselement (6a - 10a) aufweist,
b) welches mit einer Leiterplatte-Metallanschlussfläche (4a) verlötet ist,
c) die auf einer Bauelementseite (2) der Leiterplatte (1) in der gewünschten Bauelementposition angebracht ist,
d) wobei das metallische Lötanschlusselement (6a - 10a) des drahtlosen Bauelementes (6 - 10) mindestens mit einem Abschnitt in einer vertikalen Verlängerung eines Endes eines Lötloches (15) in der Leiterplatte (1) angeordnet ist,
dadurch gekennzeichnet,
e) dass das metallische Lötanschlusselement (6a - 10a) des drahtlosen Bauelementes (6 - 10) von der Leiterplatte-Metallanschlussfläche (4a) einen vertikalen Abstand von mindestens 100 µm hat.

7. Leiterplatte nach Anspruch 6, dadurch gekennzeichnet, dass das Lötloch (15) ein Bohrloch mit einem Durchmesser im Bereich von 0,2 mm - 0,9 mm ist.

8. Leiterplatte nach Anspruch 7, dadurch gekennzeichnet, dass das Lötloch (15) ein Bohrloch mit einem Durchmesser von 0,3 mm - 0,4 mm ist.

9. Leiterplatte nach einem der Ansprüche 6 bis 8, dadurch gekennzeichnet, dass sich das Bauelement (10) auf einer der der Bauelementseite gegenüberliegenden zweiten bzw. Lötseite (3) der Leiterplatte (1) befindet.

10. Leiterplatte nah einem der Ansprüche 6 bis 9, dadurch gekennzeichnet, dass die Leiterplatte-Metallanschlussfläche (4a) der Lochmetallisierung (4) flächenmässig grösser ist als die entsprechende Fläche der Lochmetallisierung auf der Gegenseite der Leiterplatte (1), an der kein Bauelement angelötet ist.

## Claims

1. Method for soldering a wireless component (6 - 10) to a printed-circuit metal connecting surface (4a),
a) which is fitted, before soldering, to a first or component side (2) of a printed-circuit board (1),
b) the component having at least one metallic solder connecting element (6a - 10a) and
c) being fixed in its geometrical orientation, before soldering in the desired soldering position on the component side of the printed-circuit board, such that at least one region or section of at least one metallic solder connecting element (6a - 10a) of the component (6 - 10) is located in a vertical extension of one end of a soldering hole (15) in the printed-circuit board (1),
d) the at least one metallic solder connecting element of the component subsequently being soldered, by flow soldering, from the soldering side of the printed-circuit board, to at least one printed-circuit board metal connecting surface (4a),
characterised in that
e) the solder connecting element (6a - 10a) of the component (6 - 10) is spaced apart from the printed-circuit board metal connecting surface (4a), by means of an intermediate air space, before soldering, so that flux gases can escape during soldering.

2. Method according to Claim 1, characterised in that the flow soldering takes place using a turbulent soldering wave, whose turbulence is at least partially caused by an oscillator having a vibration amplitude which can be predetermined, or by means of a double wave comprising a hollow wave and a subsequent solid wave.

3. Method according to Claim 1 or 2, characterised in that the component (10) is located on a second or soldering side (3) of the printed-circuit board (1) opposite the component side.

4. Method according to one of Claims 1 to 3, characterised in that the solder connecting element (6a - 10a) is at a minimum vertical distance of 100 µm from one end of the soldering hole (15) or from the printed-circuit board metal connecting surface (4a).

5. Method according to one of Claims 1 to 4, characterised in that
a) the wireless component (6 - 10) is bonded to the printed-circuit board (1) before soldering, in order to fix the geometric orientation, and
b) the adhesive is cured by heat treatment, before soldering.

6. Printed-circuit board (1) having at least one wireless component (6 - 10),
a) which has at least one metallic solder connecting element (6a - 10a),
b) which is soldered to a printed-circuit board metal connecting surface (4a),
c) which is fitted in the desired component position on a component side (2) of the printed-circuit board (1),
d) the metallic solder connecting element (6a - 10a) of the wireless component (6 - 10) being arranged with at least one section in a vertical extension of one end of a soldering hole (15) in the printed-circuit board (1),
characterised in that
e) the metallic solder connecting element (6a - 10a) of the wireless component (6 - 10) is at a vertical distance of at least 100 µm from the printed-circuit board metal connecting surface (4a).

7. Printed-circuit board according to Claim 6, characterised in that the soldering hole (15) is a drilled hole having a diameter in the range from 0.2 mm - 0.9 mm.

8. Printed-circuit board according to Claim 7, characterised in that the soldering hole (15) is a drilled hole having a diameter of 0.3 mm - 0.4 mm.

9. Printed-circuit board according to one of Claims 6 to 8, characterised in that the component (10) is located on a second or soldering side (3) of the printed-circuit board (1), opposite the component side.

10. Printed-circuit board according to one of Claims 6 to 9, characterised in that the printed-circuit board metal connecting surface (4a) of the hole metallisation (4) is larger, in area terms, than the corresponding area of the hole metallisation on the opposite side of the printed-circuit board (1), to which no component is soldered.

## Revendications

1. Procédé de brasage d'un composant sans fil (6 - 10) à une plage métallique de raccordement (4a) d'une plaquette à circuits imprimés,
a) qui est appliquée avant le brasage à une première face, respectivement à une face à composants (2) d'une plaquette à circuits imprimés (1),
b) où le composant présente au moins un élément métallique de raccordement de brasage (6a - 10a) et
c) est fixé avant le brasage sur la face à composants de la plaquette à circuits imprimés dans sa place géométrique dans sa position de brasage désirée de telle sorte qu'il se trouve au moins une région ou un tronçon d'au moins un élément métallique de raccordement de brasage (6a - 10a) du composant (6 - 10) dans un prolongement vertical d'une extrémité d'un trou de brasage (15) dans la plaquette à circuits imprimés (1),
d) et où ensuite ledit au moins un élément métallique de raccordement de brasage du composant est brasé à partir de la face à braser de la plaquette à circuits imprimés par brasage au fondant à au moins une plage métallique de raccordement (4a) de la plaquette à circuits imprimés,
caractérisé en ce que
e) l'élément de raccordement de brasage (6a - 10a) du composant (6 - 10) est, avant le brasage, écarté de la plage métallique de raccordement (4a) de la plaquette à circuits imprimés par un intervalle d'air par lequel les gaz du fondant peuvent s'échapper au cours du brasage.

2. Procédé suivant la revendication 1, caractérisé en ce que le brasage au fondant est effectué avec une onde de brasage turbulente, dont la turbulence est provoquée par un oscillateur ayant une amplitude de vibration prévisible ou au moyen d'une onde double composée d'une onde creuse et d'une onde pleine consécutive.

3. Procédé suivant la revendication 1 ou 2, caractérisé en ce que le composant (10) se trouve sur une seconde face, respectivement une face à braser (3) de la plaquette à circuits imprimés (1), opposée à la face à composants.

4. Procédé suivant l'une ou l'autre des revendications 1 à 3, caractérisé en ce que l'élément de raccordement de brasage (6a - 10a) présente une distance verticale d'au moins 100 µm à partir d'une extrémité du trou de brasage (15) respectivement de la plage métallique de raccordement (4a) de la plaquette à circuits imprimés.

5. Procédé suivant l'une ou l'autre des revendications 1 à 4, caractérisé en ce que
a) le composant sans fil (6 - 10) est collé sur la plaquette à circuits imprimés (1) avant le brasage pour fixer sa position géométrique, et en ce que
b) la colle est durcie par un traitement à la chaleur avant le brasage.

6. Plaquette à circuits imprimés (1) avec au moins un composant sans fil (6 - 10),
a) qui présente au moins un élément métallique (6a - 10a) de raccordement de brasage,
b) lequel est brasé sur une plage métallique de raccordement (4a) de la plaquette à circuits imprimés,
c) qui est formée sur une face à composants (2) de la plaquette à circuits imprimés (1) dans la position désirée du composant,
d) où l'élément métallique de raccordement de brasage (6a - 10a) du composant sans fil (6 - 10) est disposé au moins avec un tronçon dans un prolongement vertical d'une extrémité d'un trou de brasage (15) dans la plaquette à circuits imprimés (1),
caractérisée en ce que
e) l'élément métallique de raccordement de brasage (6a - 10a) du composant sans fil (6 - 10) présente une distance verticale d'au moins 100 µm par rapport à la plage métallique de raccordement (4a) de la plaquette à circuits imprimés.

7. Plaquette à circuits imprimés suivant la revendication 6, caractérisée en ce que le trou de brasage (15) est un trou foré ayant un diamètre compris dans la gamme de 0,2 mm à 0,9 mm.

8. Plaquette à circuits imprimés suivant la revendication 7, caractérisée en ce que le trou de brasage (15) est un trou foré ayant un diamètre de 0,3 mm à 0,4 mm.

9. Plaquette à circuits imprimés suivant l'une ou l'autre des revendications 6 à 8, caractérisée en ce que le composant (10) se trouve sur une seconde face, respectivement sur une face à braser (3) de la plaquette à circuits imprimés (1), opposée à la face à composants.

10. Plaquette à circuits imprimés suivant l'une ou l'autre des revendications 6 à 9, caractérisée en ce que la plage métallique de raccordement (4a) de la plaquette à circuits imprimés du trou métallisé (4) est plus grande en étendue que la plage correspondante du trou métallisé sur la face opposée de la plaquette à circuits imprimés (1) auquel aucun composant n'est brasé.
